# EUROPEAN PATENT SPECIFICATION

(11) **EP 2 846 359 B1**
(45) Date of publication and mention of the grant of the patent: **17.01.2018**
(21) Application number: 13183428.5
(22) Date of filing: 06.09.2013
(51) Int. Cl.: H01L 29/87, H01L 29/06

(54) **LVTSCR device**
LVTSCR-Anordnung
Dispositif de type LVTSCR

(43) Date of publication of application: 11.03.2015
(73) Proprietor: IMEC VZW, 3001 Leuven (BE)
(72) Inventor: Chen, Shih-Hung, 3001 Leuven (BE); Linten, Dimitri, 3001 Leuven (BE)
(74) Representative: Mackett, Margaret

(56) References cited:
- US-A- 5 465 189
- GRIFFONI A ET AL: "Next generation bulk FinFET devices and their benefits for ESD robustness", 2009 31ST ELECTRICAL OVERSTRESS/ELECTROSTATIC DISCHARGE SYMPOSIUM (EOS/ESD 2009), ANAHEIM, CA, USA, 30 August 2009 (2009-08-30), - 4 September 2009 (2009-09-04), pages 1-10, XP031570825, IEEE, New York, NY, USA ISBN: 978-1-58537-176-1

## Description

### Field of the disclosure

The present disclosure relates to improvements in or relating to electrostatic discharge protection devices and is more particularly concerned with low voltage trigger silicon controlled rectifier devices implemented using bulk fin field effect transistor technology.

### Background of the disclosure

Electrostatic discharge is known to be a problem in semiconductor devices, and electrostatic discharge protection devices are implemented in such semiconductor devices. Electrostatic discharge protection devices are triggered, that is, switched from an 'off' state to an 'on' state, when an abnormal external pulse is experienced to protect the semiconductor device and its associated circuit. These protection devices are normally returned to their normal 'off' state when the abnormal external pulse has subsided, and should be kept in an 'off' or non-operational state during normal operation of the semiconductor device and its associated circuit.

It is known to use silicon controlled rectifier devices to provide protection against electrostatic discharge due their superior area efficiency which provides electrostatic discharge robustness. However, such devices tend to have relatively high trigger voltages and there is a risk of mis-triggering into an 'on' state, followed by a transition into a latchup state with high leakage currents, under normal circuit operating conditions. Such high trigger voltages and risk of latchup tend to be prohibitive in certain real applications, such as, advanced complementary metal oxide semiconductor (CMOS) technologies and power-rail electrostatic discharge protection.

Low voltage trigger silicon controlled rectifier devices have been used to reduce the trigger voltage. Such devices have been widely implemented in sub-micrometer CMOS integrated circuit products, for example, as a grounded gate n-channel CMOS device. Whilst such low voltage trigger silicon controlled rectifier devices solve the problem of the high trigger voltage by triggering at a lower trigger voltage, they still have a risk of latchup during normal operational conditions of the circuit they are intended to protect.

US-B-8455947 describes a fin field effect transistor type device which can be used for electrostatic discharge protection. The device comprises a bipolar device portion and an n-channel metal oxide semiconductor device portion, the two portions being connected to one another. Each of the bipolar device portions and n-channel metal oxide semiconductor device portions comprises first, second and third doped regions. Each n-channel metal oxide semiconductor device portion is directly coupled to the bipolar device portion via the second doped portion of the bipolar device portion and the differently doped region of the n-channel metal oxide semiconductor device portion. A gate is formed which is effectively wrapped around the second doped region of the n-channel metal oxide semiconductor device portion. This results in a structure where different orientations are required between the bipolar device portion and the n-channel metal oxide semiconductor device portion, and, such a structure cannot be implemented in current state of the art bulk fin field effect transistor technology.

US-A-2009/0309167 describes the use of electrostatic protection devices in a two-stage electronic device in which a first stage and a second stage are respectively connected to an input line and an output line as well to one another, and, to primary and secondary voltage supplies. Electrostatic discharge protection devices are provided at the input and the output of the electronic device and are connected between input and output lines and each of the primary and secondary supplies. The electrostatic discharge protection devices can be configured as either a metal oxide semiconductor device or as a fin-based bipolar device where the bipolar device forms a silicon controlled rectifier device.

However, these electrostatic protection devices require an extra doped epitaxial layer to be able to provide electrostatic discharge protection. In addition, such devices are not low voltage and do not address the issue of latchup and latchup immunity.

US-A-2007/0262386 describes an electrostatic discharge protection device in which a plurality of electrostatic discharge protection elements is connected in parallel, each electrostatic discharge protection element including a fin structure. At least one gate region is formed on or above the fin structures which is connected to a gate control circuit. The gate control circuit acts as a trigger for the electrostatic discharge protection device. The fin structures may be implemented in multi-gate field effect transistor technology and each fin may comprise a stacked silicon controlled rectifier structure in which a plurality of silicon controlled rectifier elements is provided with no isolation structures, for example, shallow trench isolation structures, between the silicon controlled rectifier elements.

In this case, the gate control circuits are connected in parallel with an element of an electrical circuit that is to be protected. The detection of an electrostatic discharge event changes the state of the gate to which the gate control circuit is connected so that the current generated by the event can be dissipated. Whilst a silicon controlled rectifier structure is provided, the trigger voltage is determined by the gate control circuit and not by the silicon controlled rectifier structure itself.

US-A-5465189 discloses a semiconductor controlled rectifier which may be used to provide on-chip protection for integrated circuit devices against electrostatic discharge applied at the input, output, power supply pins or between any arbitrary pairs of pins thereof. Such an integrated circuit device is defined by a structure having a low trigger voltage determined by a low breakdown voltage.

Generally speaking, none of the documents discussed above appears to relate to low voltage trigger silicon controlled rectifiers which can have higher trigger voltages without suffering from the effects of latchup during normal operating conditions of a circuit that the low voltage trigger silicon controlled rectifier is intended to protect. Moreover, none of these documents discloses the implementation of an electrostatic discharge protection device in bulk fin field effect transistor technology.

In addition, with the trend towards sub-20nm node technology and the associated modifications required in processes to be able to shrink the footprint of bulk fin field effect transistor type devices, fin widths need to be considered as it has been shown that they are essential parameters relating to electrostatic discharge characteristics as discussed by A. Griffoni et al. in "Next generation bulk FinFET devices and their benefits for ESD robustness", EOS/ESD Symposium, 2009, pages 59 to 68. For example, all current produced due to electrostatic discharge needs to be discharged through the fins, which due to their small sizes, tend to induce localised 'hot spots' which results in a deterioration in robustness against electrostatic discharge.

### Summary of the disclosure

It is an object of the present disclosure to provide an electrostatic discharge protection device which operates on a higher trigger current than conventional low voltage trigger electrostatic discharge protection devices whilst substantially reducing the risk of mis-triggering and subsequent transition to a latchup state during normal operating conditions of the electronic device and/or circuit which it is intended to protect.

In accordance with one aspect of the present disclosure, there is provided an electrostatic discharge protection device comprising a low voltage trigger silicon controlled rectifier including:
a first region having:-
   a first doped area of a first doping type,
   a second doped area of a second doping type, and
   a third doped area of the first doping type,
a second region having:-
   a fourth doped area of the first doping type, and
   a fifth doped area of the second doping type;
one of the first and second regions defining an anode and the other of the first and second regions defining a cathode; and
a grounded gate metal oxide semiconductor structure having a gate and an avalanche zone in the locality of the gate;
characterised in that the grounded gate metal oxide semiconductor structure comprises a bulk fin-based transistor architecture connecting the third doped area of the first region and the fourth doped area of the second region to one another and including a plurality of fin elements extending under the gate and a plurality of shallow trench isolation structures formed in between and adjacent to the plurality of fin elements with the avalanche zone being created in the third doped area adjacent the gate.

An advantage of the combination of the low voltage trigger silicon controlled rectifier and a fin based transistor architecture is that, whilst low voltages are provided which keep the current/voltage characteristic within an electrostatic discharge protection design window, high trigger currents can be implemented whilst substantially reducing the risk of latchup during normal operating conditions.

The pitch between the fin elements may be in the range of between 40nm and 200nm. Preferably, the pitch between the fin elements is 200nm.

Each fin element may have a width in the range of between 7nm and 45nm, preferably between 10nm and 40nm, and most preferably a width of 20nm.

Preferably, the grounded gate metal oxide semiconductor structure comprises a grounded gate n-channel metal oxide semiconductor structure.

### Brief description of the drawings

For a better understanding of the present disclosure, reference will now be made, by way of example, to the accompanying drawings in which:-
Figure 1 is a schematic illustration of a current/voltage characteristic for silicon controlled rectifiers and for low voltage trigger silicon controlled rectifiers;
Figure 2 illustrates a schematic cross-section view of a silicon controlled rectifier;
Figure 3 illustrates a schematic cross-section view of a low voltage trigger silicon controlled rectifier;
Figure 4 is a schematic illustration of a top view of a low voltage trigger silicon controlled rectifier having a planar embedded grounded gate n-channel metal oxide semiconductor device;
Figure 5 is a schematic illustration of a top view of a low voltage trigger silicon controlled rectifier having a fin field effect transistor embedded grounded gate n-channel metal oxide semiconductor device in accordance with the present disclosure; and
Figure 6 illustrates current/voltage characteristics for the devices shown in Figures 4 and 5.

### Description of the disclosure

The present disclosure will be described with respect to particular embodiments and with reference to certain drawings but the disclosure is not limited thereto. The drawings described are only schematic and are non-limiting. In the drawings, the size of some of the elements may be exaggerated and not drawn on scale for illustrative purposes.

In general, grounded gate n-channel metal oxide semiconductor (GGNMOS) structures or devices have been used for electrostatic discharge (ESD) protection of integrated circuit (IC) based electronic devices. In such GGNMOS structures, the gate, source and body of the structure are electrically connected to one another and to ground. If the ESD protection is applied to an input/output (I/O) pad, for example, the drain of the GGNMOS structure is connected to the I/O pad to form a parasitic npn bipolar junction transistor (BJT) in which the n-type doped drain acts as the collector, the n-type doped source combination acts as the emitter and the p-type doped substrate acts as the base. The parasitic resistance between emitter and base terminals is defined by the finite conductivity of the p-type doped substrate.

In the example given above, when an ESD event appears at the I/O pad, that is, the drain, the collector-base junction of the parasitic npn structure becomes reverse biased and enters avalanche breakdown. A positive current flows from the base to the ground to induce a voltage across the parasitic resistor and causes a positive voltage to appear across the base-emitter junction. This positive voltage forward biases the junction turning on the parasitic npn bipolar transistor.

In the present disclosure, this positive current is within a fin field effect transistor (FinFET) structure so that it is restricted to the fins, and as such, results in an increase in the trigger current and a reduction in the possibility of mis-triggering and increasing immunity to latchup.

The term "latchup" as used herein refers to a parasitic device or system generated within a complementary metal oxide semiconductor (CMOS) structure and which enables unwanted current flow in a part of the structure. In a LVTSCR device including a GGNMOS structure as described above, two back-to-back BJTs are formed during latchup. An npn BJT current path is created due to the forward bias of the base emitter of the npn BJT, and the current flow so produced induces a voltage drop to create a forward conducting pnp BJT. In effect, a pnpn path is created which maintains the device or circuit in a latchup state at normal operating voltages.

The term "latchup immunity" as used herein refers to the immunity of a CMOS structure to turning on of the parasitic devices and to the generation of unwanted current flow in the parasitic devices of the structure.

The terms "trigger voltage" and "trigger current" as used herein respectively refer to the voltage and current at which an ESD protection device triggers, that is, switches from an 'off' state to an 'on' state. Trigger current is a direct measure of latchup performance, that is, the higher the trigger current, the better the latchup performance.

The term "trigger point" as used herein refers to a point in a current/voltage characteristic which corresponds to the trigger voltage and trigger current.

The terms "holding voltage" and "holding current" as used herein respectively refer to voltage and current required to maintain a circuit in its 'ON' state.

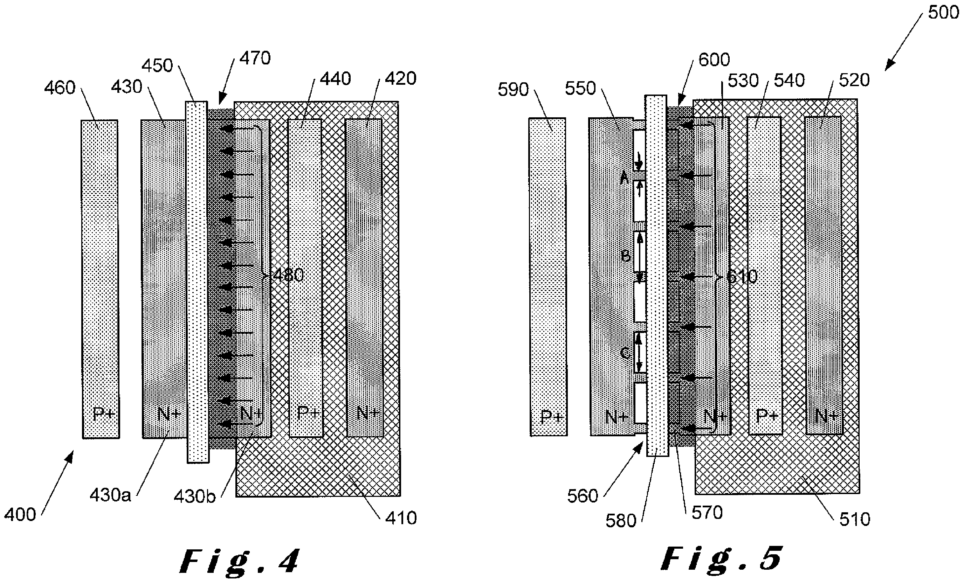

The term "fin width" as used herein refers to the width of the fin as indicated in Figure 5 by "A". The term "pitch" as used herein refers to the distance between a particular point on one fin and a corresponding point on an adjacent fin. The term "spacing" as used herein refers to the distance between fins and is equivalent to the distance determined as the pitch minus the fin width.

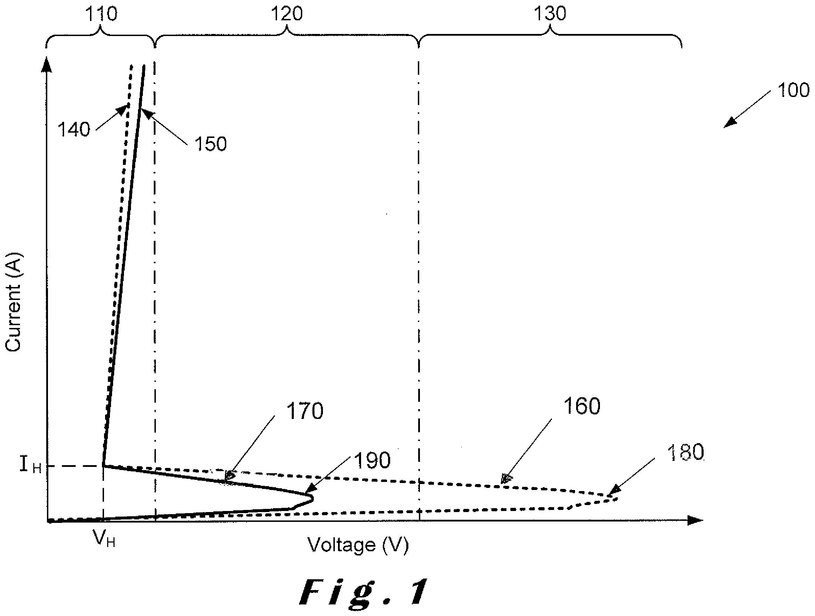

Figure 1 illustrates current/voltage characteristics for a conventional silicon controlled rectifier (SCR) device and for a low voltage trigger (LVT) SCR (LVTSCR) device represented as a graph 100. The graph 100 is divided into three zones or regions 110, 120, 130 in accordance with increasing voltage. Zone or region 110 represents latchup risk; zone or region 120 represents an electrostatic discharge (ESD) protection design window; and zone or region 130 represents gate oxide failure. The current/voltage characteristic for a conventional SCR device is indicated by lines 140, 160 and that for a conventional LVTSCR device is indicated by lines 150, 170. In addition, the holding voltage V_{H} and the holding current I_{H} for the SCR and LVTSCR devices are also shown.

For a conventional SCR device, line 140 indicates the current increase at low voltages due to latchup, and line 160 indicates the saturation characteristics for such a device with a trigger point at 180. This trigger point represents the voltage required to trigger the device for ESD protection.

Similarly, for a conventional LVTSCR device, line 150 indicates the current increase at low voltages with line 170 representing the saturation characteristics and having a trigger point 190. As before, this trigger point represents the voltage required to trigger the device for ESD protection.

The interface between zones or regions 110 and 120 corresponds to the operating voltage (V_{DD}) of the device, and the interface between zones or regions 120 and 130 corresponds to the failure voltage of the device.

As shown, the characteristic of the SCR device requires a trigger voltage of around 15V which is considerably larger than a trigger voltage of around 5V required by the LVTSCR device. By requiring such a high trigger voltage, the SCR characteristic moves into the gate oxide failure zone or region 130 which can cause serious damage to a device which such a device is intended to protect. As can be seen, the LVTSCR characteristic remains within the zone or region 120 and therefore provides protection for the device which it is intended to protect.

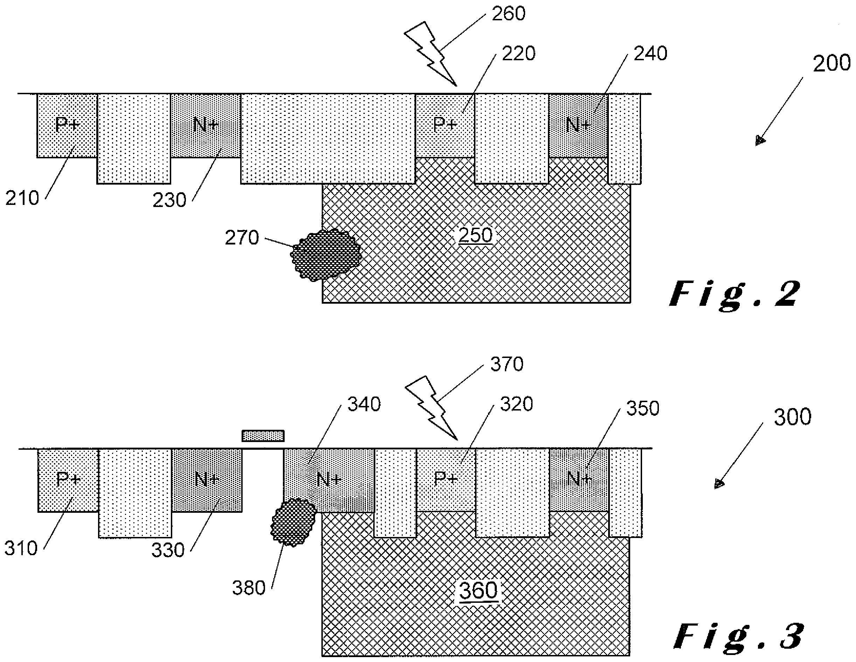

In Figure 2, an SCR device 200 is shown which comprises p+ doped regions 210, 220 and n+ doped regions 230, 240. N+ doped region 230 and p+ doped region 210 are formed in a p-type material, for example, a suitably doped substrate (not shown). N+ doped region 240 and p+ doped region 220 are formed in an n-well 250. The n-well 250 is formed in the p-type material or substrate. An ESD 260 generates a high bulk-drain or base-collector voltage as is shown schematically at 270 for the device 200.

In Figure 3, a LVTSCR device 300 is shown which comprises p+ doped regions 310, 320 and n+ doped regions 330, 340, 350. N+ doped region 330, p+ doped region 310 and a part of the n+ doped region 340 are formed in a p-type material or substrate (not shown). N+ doped region 350, p+ doped region 320 and part of n+ doped region 340 are formed in an n-well 360. The n-well 360 is formed in the p-type material or substrate. An ESD 370 generates a low bulk-drain or base-collector voltage as is shown schematically at 380 for the device 300.

In accordance with the present disclosure, an embedded GGNMOS structure with bulk fin field effect transistor (FinFET) is applied to a LVTSCR device to increase its trigger current and thereby enhance its immunity to latchup. This has the advantage that the current flowing through the device can be re-distributed and restrained locally within the FinFET configuration as will be described in more detail below.

By way of comparison, an LVTSCR device 400 including a planar embedded GGNMOS device is shown in Figure 4. The device 400 comprises a first region 410 having n+ doped areas 420, 430 and a p+ doped area 440. The first region 410 comprises an n-well which is formed in a p-type material or substrate (not shown). A gate 450 is formed on a p-type material or substrate (not shown) which effectively separates the n+ doped area 430 into two sub-areas 430a, 430b. Another p+ doped area 460 is also provided.

Although the n+ doped area 430 is described as being a single n+ doped area which is effectively partitioned by the gate 450, it will be appreciated that each of the sub-areas 430a, 430b may comprise separate areas with the gate 450 being located between the two separate areas.

It will readily be understood that p+ doped area 460, n+ doped sub-area 430a and a part of n+ doped sub-area 430b are formed in the p-type material or substrate, and n+ doped area 420, p+ doped area 440 and a part of n+ doped sub-area 430b are formed in the n-well or region 410.

In the device 400, an anode is defined by the n+ doped area 420, p+ doped area 440 and, a cathode is defined by n+ doped area 430a and the p+ doped area 460.

It will readily be understood that, due to the high doping of the areas 420, 430, 440, 460, the LVTSCR device 400 would normally be implemented using a plurality of shallow trench isolation (STI) structures or zones for isolating the highly doped areas from the structure in which they are formed. In the case of p+ doped area 460, n+ doped sub-area 430a and part of n+ doped sub-area 430b, STI structures or zones (not shown) are provided to isolate each of these areas and sub-areas from the p-type material or substrate. Similarly, for n+ doped area 420, p+ doped area 440 and part of n+ doped sub-area 430b, STI structures or zones (not shown) are provided to isolate each of these areas from the n-well or first region 410 in which they are formed.

Although the STI structures or zones are not shown in Figure 4, it would be apparent to a person skilled in the art where they would be located to provide the isolation required for operation of the LVTSCR device 400.

When an ESD event occurs, an avalanche zone 470 is created in the n+ doped sub-area 430b of the n+ doped area 430 adjacent the gate 450 when avalanche breakdown occurs to generate current flow towards the gate 450 through sub-area 430b.

In the embodiment described, the device 400 has a total device width of 40µm in a direction which corresponds with the gate width, with an anode to cathode distance of 840nm.

An LVTSCR device 500 in accordance with the present disclosure is shown in Figure 5. The device 500 is similar to the device 400 and comprises a first region 510 having an n+ doped area 520, a p+ doped area 540 and a part of an n+ doped area 530. The first region 510 comprises an n-well which is formed in a p-type material or substrate (not shown). N+ doped area 530 is connected to another n+ doped area 550 by means of a FinFET structure 560 comprising a plurality of fins 570 (only one of which is labelled for clarity) as shown. A gate 580 formed over the FinFET structure 560. A separate p+ doped area 590 is also provided. N+ doped area 550, p+ doped area 590 and a part of n+ doped area 530 are formed in the p-type material or substrate (not shown).

In a particular embodiment of the present disclosure, the orientation of the p+ doped area 540 is such that its edge adjacent to n+ doped area 530 is parallel to the edge of n+ doped area 530 with a substantially equal spacing between the two doped areas 530, 540. The edge of the p+ doped area 540 preferably has the same dimension as the edge of the adjacent n+ doped area 530, but is not limited thereto, and therefore the edge of the p+ doped area 540 may be longer or shorter than the edge of the adjacent n+ doped area 530.

The p+ doped area 590 as shown in Figure 5 is drawn to be adjacent to n+ doped area 550, with the adjacent edges running in parallel and having an essentially equal spacing. In addition, the edges of the two doped areas have essentially the same dimensions. Whilst this is a preferred topology, it should be noted that it is possible to have variations on this without substantially affecting the performance of the LVTSCR device in accordance with the present disclosure. This also applies to n+ doped area 520 in relation to p+ doped area 540.

In the device 500 in accordance with the present disclosure, an anode is defined by the n+ doped area 520, p+ doped area 540, and a cathode is defined by the n+ doped area 550 and p+ doped area 590. It will be obvious to the skilled person that although the anode and cathode each comprise two different doped areas or zones, i.e. n+ and p+, which are normally physically separated, they can be considered as a unitary element as the two differently doped areas or zones are electrically connected to one another at another level to form an LVTSCR structure. It is also to be noted that according to a specific embodiment of the present disclosure, the two differently doped areas or zones comprising either the cathode or the anode can be partially or fully joined to form an abutted unitary element.

A plurality of STI structures or zones is formed in the p-type material or substrate and the n-well or region 510 for isolating the highly doped areas from the structure in which they are formed. In the case of p+ doped area 590, n+ doped area 550 and part of n+ doped area 530, STI structures or zones (not shown) are provided to isolate each of these areas and sub-areas from the p-type material or substrate. Similarly, for n+ doped area 520, p+ doped area 540 and part of n+ doped area 530, STI structures or zones (not shown) are provided to isolate each of these areas from the n-well or first region 510 in which they are formed.

Although the STI structures or zones are not shown in Figure 5, it would be apparent to a person skilled in the art where they would be located to provide the isolation required for operation of the LVTSCR device 500 in accordance with the present disclosure. It is of particular interest to note that the un-doped zones in between and adjacent to the plurality of fins 570 are actually STI.

When an ESD event occurs where a positive voltage is applied between the anode and the cathode, an avalanche zone 600 is created in the n+ doped area 530 adjacent the gate 580 when avalanche breakdown occurs to generate current flow towards the gate 580 through n+ doped area 530. In this case, the current is directed in the direction of arrows 610 towards the gate 580 through n+ doped area 530 and fins 570 of the FinFET structure 560. In effect, due to the fin configuration of the embedded GGNMOS device, the active region of the n+ doped area 530 is effectively limited or reduced as the flow of current is constrained by the fins 570. Indeed, the un-doped zones, which exclude the n+ or p+ doped areas and the plurality of fins, in between the plurality of fins 570 are actually STI and obstruct the current flow compared to prior art implementations that do not have this feature.

In the LVTSCR structure of the device shown in Figure 5, a parasitic diode is formed by the n-well and p-type material or substrate. When an ESD event occurs which has the effect of applying a negative voltage between the anode and the cathode, the parasitic diode behaves as a simple diode to protect the circuit which is to be protected.

Although the n+ doped areas and p+ doped areas, defined by two zones 550/590 and 520/540 are shown to be separated from one another in both the p-type material or substrate and the n-well, it will be appreciated that these areas can either be spaced from one another as shown or abut one another as the STI structures or zones provide the necessary isolation. As a result of the abutment of the doped areas, the parasitic resistance of the p-type material (or substrate) and the n-well can be reduced with a possible increase in trigger current.

In the embodiment described, the device 500 has a total device width of 40µm as before and a fin width of 20nm with a pitch of 200nm (or a spacing of 180nm) between fins. In Figure 5, the fin width is indicated at 'A'; the pitch is indicated at 'B'; and the spacing is indicated at 'C'. The anode to cathode distance is 840nm as before. However, fin widths may be in the range of between 7nm and 45nm, preferably between 10nm and 40nm, most preferably between 10nm and 30nm. Pitches may be in the range of 40nm and 200nm, preferably between 60nm and 200nm, and most preferably between 100nm and 200nm. In another specific embodiment, a device 500 has a fin width of 10nm with a pitch of 45nm (or spacing of 35nm) between fins.

It will be appreciated that other fin widths and pitches can be implemented according to a particular application, and the values given above are not intended to be limiting. The width of the fins and the pitch between fins determine the number of fins present in the bulk FinFET structure in accordance with the overall device width. In the specific embodiment described with reference to Figure 5, for an overall device width of 40µm and a fin width of 20nm and a pitch of 200nm, the number of fins is 200.

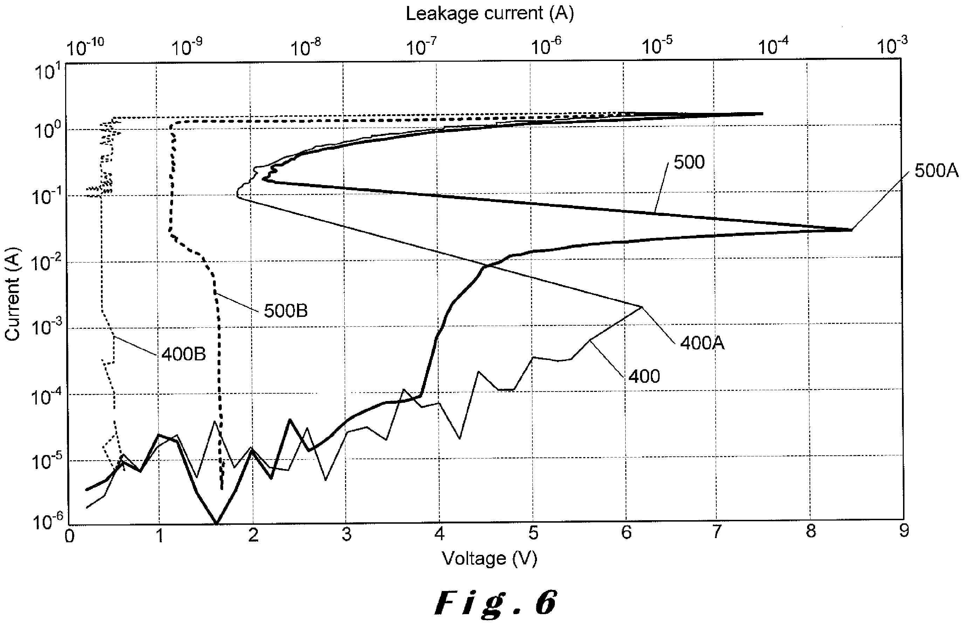

Test results comparing the trigger current for the LVTSCR device 400 of Figure 4 and the LVTSCR device 500 of Figure 5 are shown in Figure 6. The results obtained for the device 400 of Figure 4 is labelled as '400' and the results obtained for the device 500 of Figure 5 is labelled as '500'. It can readily be seen that the trigger point for the device 400, labelled as '400A', corresponds to a trigger current of around 2mA and trigger voltage of around 6.2V. Similarly, the trigger point for the device 500, labelled as '500A', corresponds to a trigger current of around 26mA and a voltage of around 8.4V. Therefore, with the device 500, a trigger current over 10 times larger than that obtained for the device 400 can be obtained. A slight increase in holding voltage V_{H} is also obtained. The results are summarised in Table 1 below.

**Table 1.**

| Parameters | Device 400 | Device 500 | Difference |
|---|---|---|---|
| Trigger voltage | 6.2V | 8.4V | Increase of 2V |
| Trigger current | 2mA | 26mA | 10 times increase |
| Holding voltage | 1.6V | 1.8V | Increase of 0.2V |

The increase in both trigger current and trigger voltage are attributed to the presence of multiple fins and the STI in between the fin spaces particularly in the avalanche region 600. The presence of the fins has the effect of restraining the area defined by region 530, by having STI regions between the fins, so that parasitic bipolar, npn and pnp structures cannot obtain sufficient current to become active. As a consequence, the LVTSCR device in accordance with the present disclosure cannot be fully triggered in low current conditions.

It is to be noted that although the trigger voltage has been increased in the embodiment of the present disclosure as shown in Figure 6, it will readily be understood that the increase in trigger voltage is still within the ESD protection design window as indicated by region or zone 120 in Figure 1.

The leakage current for the two devices is also shown in Figure 6. The result for device 400 is labelled as '400B' and the result for device 500 is labelled as '500B'.

The types of materials and/or doping concentrations that can be used for the substrate, n-well, p+ and n+ regions are well known to a person skilled in the art and no specific materials have been described here. However, it will be appreciated that although the present disclosure has been described with reference to an embedded GGNMOS structure, it will be appreciated that GGPMOS structures could also be used with appropriate materials and/or doping concentrations. In the embodiment of the present disclosure, only standard processing steps are required and no additional doping processes or steps are necessary to implement the fin structure thereof. Preferably, all n+ doped areas are formed in the same process step and all p+ doped areas are formed in the same process step. Preferably, the fin structure is produced using double patterning technology, a photolithography process for defining the fins and the spacing between each fin.

Although the present disclosure has been described with reference to a specific embodiment, it will readily be understood that other embodiments of a LVTSCR with an embedded GGNMOS (or GGPMOS) structure are also possible.

## Claims

1. An electrostatic discharge protection device (500) comprising a low voltage trigger silicon controlled rectifier including:
a first region (510) having:-
a first doped area (520) of a first doping type,
a second doped area (540) of a second doping type, and
a third doped area (530) of the first doping type,
a second region having:-
a fourth doped area (550) of the first doping type, and
a fifth doped area (590) of the second doping type;
one of the first and second regions defining an anode and the other of the first and second regions defining a cathode; and
a grounded gate metal oxide semiconductor structure having a gate (580) and an avalanche zone (600) in the locality of the gate (580);
**characterised in that** the grounded gate metal oxide semiconductor structure comprises a bulk fin-based transistor architecture (560) connecting the third doped area (530) of the first region and the fourth doped area (550) of the second region to one another and including a plurality of fin elements (570) extending under the gate (580) and a plurality of shallow trench isolation structures formed in between and adjacent to the plurality of fin elements (570) with the avalanche zone (600) being created in the third doped area (530) adjacent the gate (580).

2. A device according to claim 1, wherein the pitch between fin elements (570) is in the range of between 40nm and 200nm.

3. A device according to claim 2, wherein the pitch between fin elements (570) is 200nm.

4. A device according to any one of claims 1 to 3, wherein each fin element (570) has a width in the range of between 7nm and 45nm.

5. A device according to claim 4, wherein each fin element (570) has a width in the range of between 10nm and 40nm.

6. A device according to claim 5, wherein each fin element (570) has a width of 20nm.

7. A device according to any one of the preceding claims, wherein the grounded gate metal oxide semiconductor structure is a grounded gate n-channel metal oxide semiconductor structure.

## Patentansprüche

1. Eine Schutzvorrichtung gegen elektrostatische Entladungen (500), welche einen durch Niederspannung ausgelösten Silizium gesteuerten Gleichrichter umfasst, welche Folgendes umfasst:
eine erste Region (510) mit:-
einem ersten dotierten Bereich (520) eines ersten Dotierungstyps,
einem zweiten dotierten Bereich (540) eines zweiten Dotierungstyps, und
einem dritten dotierten Bereich (530) des ersten Dotierungstyps,
eine zweite Region mit:-
einem vierten dotierten Bereich (550) des ersten Dotierungstyps, und
einem fünften dotierten Bereich (590) des zweiten Dotierungstyps;
wobei eine der ersten und der zweiten Region eine Anode definiert und die andere der ersten und der zweiten Region eine Kathode definiert; und
eine Metalloxid-Halbleiterstruktur mit geerdetem Gate mit einem Gate (580) und einer Avalanchezone (600) an der Position des Gates (580);
**dadurch gekennzeichnet, dass** die Metalloxid-Halbleiterstruktur mit geerdetem Gate eine Bulk-Finnenbasierte Transistorarchitektur (560) umfasst, welche den dritten dotierten Bereich (530) der ersten Region und den vierten dotierten Bereich (550) der zweiten Region miteinander verbindet und eine Vielzahl von Finnenelementen (570) umfasst, welche sich unter dem Gate (580) erstrecken, sowie eine Vielzahl von Isolationsstrukturen mit flacher Rinne, welche zwischen und angrenzend an die Vielzahl von Finnenelementen (570) geformt sind, wobei die Avalanchezone (600) im dritten dotierten Bereich (530) angrenzend am Gate (580) erzeugt wird.

2. Eine Vorrichtung nach Anspruch 1, wobei die Steigung zwischen Finnenelementen (570) im Bereich von zwischen 40 nm und 200 nm liegt.

3. Eine Vorrichtung nach Anspruch 2, wobei die Steigung zwischen Finnenelementen (570) 200 nm beträgt.

4. Eine Vorrichtung nach irgendeinem der Ansprüche 1 bis 3, wobei jedes Finnenelement (570) eine Breite im Bereich von zwischen 7 nm und 45 nm hat.

5. Eine Vorrichtung nach Anspruch 4, wobei jedes Finnenelement (570) eine Breite von zwischen 10 nm und 40 nm hat.

6. Eine Vorrichtung nach Anspruch 5, wobei jedes Finnenelement (570) eine Breite von 20 nm hat.

7. Eine Vorrichtung nach irgendeinem der vorigen Ansprüche, wobei die Metalloxid-Halbleiterstruktur mit geerdetem Gate eine n-Kanal-Metalloxid-Halbleiterstruktur mit geerdetem Gate ist.

## Revendications

1. Dispositif de protection contre les décharges électrostatiques (500) comprenant un redresseur commandé au silicium à tension de déclenchement réduite comprenant :
une première région (510) ayant :
une première zone dopée (520) d'un premier type de dopage,
une deuxième zone dopée (540) d'un second type de dopage, et
une troisième zone dopée (530) du premier type de dopage,
une seconde région ayant :
une quatrième zone dopée (550) du premier type de dopage, et
une cinquième zone dopée (590) du second type de dopage ;
l'une des première et seconde régions définissant une anode et l'autre des première et seconde régions définissant une cathode ; et
une structure semi-conductrice d'oxyde métallique à grille mise à la terre ayant une grille (580) et une zone d'avalanche (600) à l'emplacement de la grille (580) ;
**caractérisé en ce que** la structure semi-conductrice d'oxyde métallique à grille mise à la terre comprend une architecture de transistor à base d'ailerons type corps (560) connectant la troisième zone dopée (530) de la première région et la quatrième zone dopée (550) de la seconde région l'une à l'autre et comprenant une pluralité d'éléments en forme d'ailerons (570) s'étendant en dessous de la grille (580) et une pluralité de structures d'isolement à tranchées peu profondes formées entre et adjacente à la pluralité d'éléments d'ailerons (570) , la zone d'avalanche (600) étant créée dans la troisième zone dopée (530) adjacente à la grille (580).

2. Dispositif selon la revendication 1, dans lequel le pas entre les éléments d'ailerons (570) se situe dans la plage comprise entre 40 nm et 200 nm.

3. Dispositif selon la revendication 2, dans lequel le pas entre les éléments d'ailerons (570) est de 200 nm.

4. Dispositif selon l'une quelconque des revendications 1 à 3, dans lequel chaque élément d'aileron (570) a une largeur dans la plage comprise entre 7 nm et 45 nm.

5. Dispositif selon la revendication 4, dans lequel chaque élément d'aileron (570) a une largeur dans la plage comprise entre 10 nm et 40 nm.

6. Dispositif selon la revendication 5, dans lequel chaque élément d'aileron (570) a une largeur de 20 nm.

7. Dispositif selon l'une quelconque des revendications précédentes, dans lequel la structure semi-conductrice d'oxyde métallique à grille mise à la terre est une structure semi-conductrice d'oxyde métallique à canal n à grille mise à la terre.
